# EUROPEAN PATENT APPLICATION

(11) **EP 1 584 707 A1**
(43) Date of publication of application: **12.10.2005**
(21) Application number: 04026537.3
(22) Date of filing: 09.11.2004
(51) Int. Cl.: C23C 14/34, H01J 37/34

(54) **Power coupling for high-power sputtering**

(30) Priority: 08.04.2004 US 820896
(71) Applicant: Applied Films Corporation, Longmont, CO 80504 (US); Applied Films GmbH & Co. KG, 63755 Alzenau (DE)
(72) Inventor: Newcomb, Richard, Johnstown, CO 80504 (US); Geisler, Michael, 63607 Wächtersbach (DE)
(74) Representative: Schickedanz, Willi

(57) **Abstract**

A system and method for coating a substrate is described. One embodiment includes a sputtering system with a power coupler configured to deliver power to a rotatable target (195). The power coupler (210) is positioned in a vacuum chamber (115) or between the bearings (230) and the rotatable target outside the vacuum chamber to limit the current that flows through the bearing.

## Description

A portion of the disclosure of this patent document contains material that is subject to copyright protection. The copyright owner has no objection to the facsimile reproduction by anyone of the patent disclosure as it appears in the Patent and Trademark Office patent files or records but otherwise reserves all copyright rights whatsoever.

### FIELD OF THE INVENTION

The present invention relates to systems and methods for coating substances. In particular, but not by way of limitation, the present invention relates to systems and methods for sputtering material onto a substrate using a rotating magnetron system.

### BACKGROUND OF THE INVENTION

Glass is irreplaceable in a broad range of applications, such as window panes, automotive glazing, displays, and TV or computer monitor tubes. Glass possesses a unique combination of properties: it is transparent, dimensionally and chemically stable, highly scratch resistant, non-polluting, and environmentally beneficial. Nonetheless glass can be improved, particularly its optical and thermal properties

Vacuum coating is the technology of choice for adapting glass surfaces and other surfaces to suit specialized requirements or demanding applications. Vacuum coating is capable of depositing ultra-thin, uniform films on large-area substrates. Vacuum-coating technology is also the least polluting of current coating technologies. Notably, vacuum coating can be used to coat materials other than glass, including plastics and metal.

Common vacuum-coating systems sputter conductive and dielectric material from rotating magnetrons onto a substrate such as glass, plastic, or metal. Rotating magnetrons driven by direct current (DC) have been known for several years. And recently magnetrons driven by high-voltage alternating current (AC) have been introduced. These AC systems are advantageous but have been plagued by reliability and expense problems caused by the unique properties of a high-power AC system.

For example, high-power AC systems generate heat through a process known as inductive heating. This heat causes conventional bearings and seals in the vacuum-coating system to fail.

Inductive heating arises when an alternating current flows through a conductive material such as metal. The current generates an electromagnetic field that affects nearby and adjacent materials in two ways. First, magnetic materials develop a magnetic resistance to the fluctuating electromagnetic field. This resistance causes the materials to heat up. Second, the field causes electron flows (current) within conductive materials. The internal resistance to these current flows generates heat. Non-conductive materials do not heat because they have no free electrons to create the current flow.

From DE 102 13 049 A1 a system for coating a substrate is known, said system comprising a vacuum chamber, a rotatable tube inside the vacuum chamber, a shaft connected to the rotatable tube, the shaft being partially outside the vacuum chamber. This system also comprises a bearing positioned outside the vacuum chamber, the bearing being configured to rotatably engage the shaft. Further, a seal positioned between the bearing and the vacuum chamber is provided. The current has to pass sealings and bearings.

Still, from US 2002/0189939 Al an alternating current rotatable sputter cathode in a vacuum chamber is known. One or more sputter cathodes with at least a portion of said cathodes positioned within said sputter chamber are provided, and a portion of said cathode is disposed inside of a housing. A vacuum seal is operably positioned between said cathode and said housing, and means for supplying a current to the rotary sputter cathode inside of the sputter chamber is provided, thereby avoiding inductive heating of the vacuum seal.

It is an aim of the present invention to arrange a power coupling such that no current flows through bearings.

This aim is achieved by the subjects of claims 1, 12,14 or 17.

Engineers have developed several designs to minimize the impact of inductive heating in high-power, AC-coating systems. These designs, however, have proven to be difficult to service and expensive to implement. Accordingly, a system and method are needed to address this and other shortfalls of present technology and to provide other new and innovative features.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents, and alternative constructions that fall within the spirit and scope of the invention as expressed in the claims.

The present invention can provide a system and method for coating a substrate. One embodiment includes a high-power sputtering system with a power coupler configured to deliver power to a rotatable target. The power coupler is positioned to minimize the generation of inductive heating in bearings, seals, and/or rotary water unions. Other embodiments include liquid-metal electrical connectors, dry bearings designed to withstand the inductive heating associated with high-power electrical systems, and/or rotary unions.

As previously stated, the above-described embodiments and implementations are for illustration purposes only. Numerous other embodiments, implementations, and details of the invention are easily recognized by those of skill in the art from the following descriptions and claims.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawings wherein:
FIGURE 1 is a diagram of a prior-art, cantilevered, rotating-magnetron system;
FIGURE 2 is a diagram of a prior-art, dual-supported, rotating-magnetron system;
FIGURE 3 is a block diagram of a prior-art, rotating-magnetron system;
FIGURE 4 is a block diagram of a dual-supported, rotating-magnetron system;
FIGURE 5 is a block diagram of a rotating-magnetron system with a rotation drive through the bottom of the chamber;
FIGURE 6 is a block diagram of a rotating-magnetron system with a power feed through the bottom of the chamber;
FIGURE 7 is a block diagram of an alternate rotating-magnetron system with a power feed through the bottom of the chamber;
FIGURE 8 is a block diagram of rotating-magnetron system with a rotation drive through the chamber wall;
FIGURE 9 is a block diagram of rotating-magnetron system with a power feed through the chamber wall;
FIGURE 10 is a block diagram of rotating-magnetron system with a front feed;
FIGURE 11 is a block diagram of rotating-magnetron system with a power feed inside the vacuum chamber;
FIGURE 12 is a block diagram of vacuum-seal assembly;
FIGURE 13 is a schematic of a rotary water union;
FIGURE 14 is a cross-section view of a slip ring designed according to one embodiment of the present invention; and
FIGURE 15 is a side view of a slip ring designed according to one embodiment of the present invention.

### DETAILED DESCRIPTION

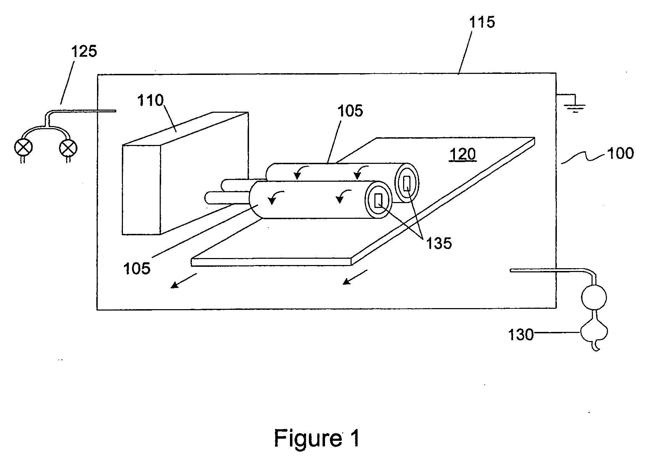

Referring now to the drawings, where like or similar elements are designated with identical reference numerals throughout the several views, and referring in particular to FIGURE 1, it illustrates a prior-art, cantilevered, rotating-magnetron system 100. This system 100 includes dual rotating cylindrical tubes 105 that are rotated by a drive system 110. The tubes 105 are coated with a target material that is sputtered using plasma formed inside the vacuum chamber 115. The sputtered target material is deposited on the substrate 120.

In certain embodiments, the tubes are actually constructed of the target material rather than coated with it. For example, the tube can be constructed of titanium, which is also the target material. Accordingly, the term "tube" can refer to a tube covered with target material or a tube constructed partially or entirely of the target material.

The plasma is formed by exciting a gas that is introduced into the vacuum chamber 115 at an inlet 125 and removed through an outlet 130. The sputtering effect is focused using a stationary magnet system 135 mounted inside the rotating tubes. An exemplary system is described in Japanese Laid-Open Patent Application 6-17247 ("Haranou") entitled *High-efficiency alternating-current magnetron sputtering device,* assigned to Asahi Glass. The content of this publication shall be incorporated in this specification.

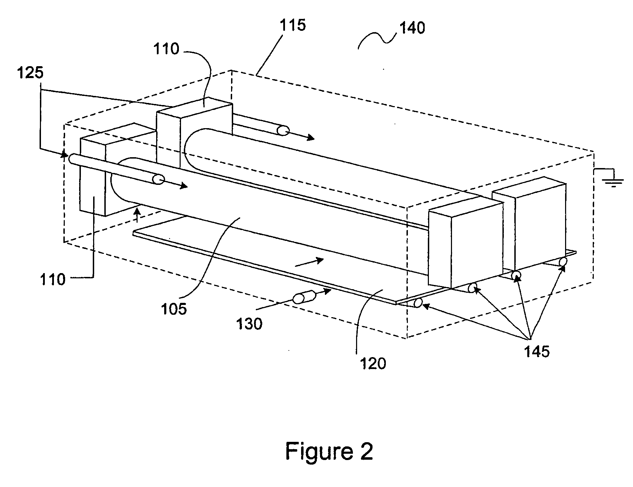

Referring now to Figure 2, it is a diagram of a prior-art, dual-supported, rotating-magnetron system 140. This system includes a vacuum chamber 115, a gas inlet 125, a gas outlet 130, a drive system 110, a power system (not shown), and two rotating tubes 105 covered with a target material. This target material is sputtered onto the substrate 120 that is being moved through the vacuum chamber by the substrate drive motors 145.

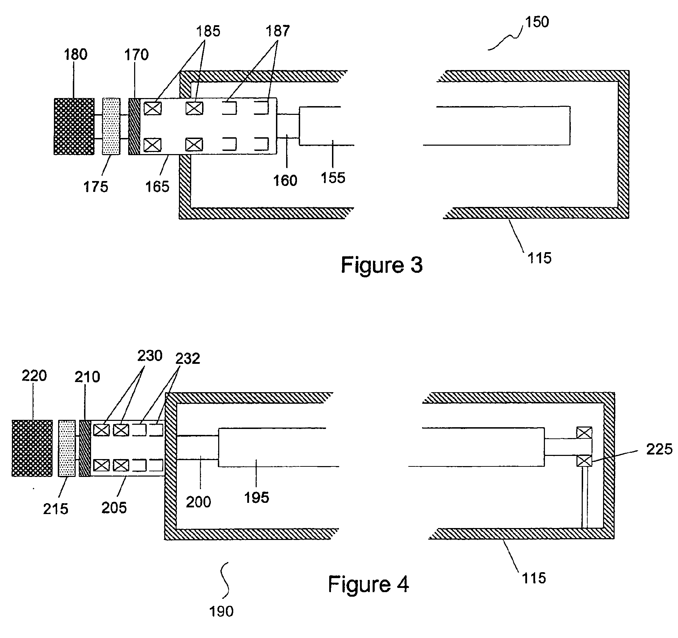

Referring now to Figure 3, it is a block diagram of a prior-art, rotating-magnetron system 150. This system includes a rotating tube 155 connected to a shaft 160. This shaft 160 is connected to a bearing and seal assembly 165, a power coupling 170, and a rotation drive 175. The shaft 160 is also coupled to a water supply 180 so that water can be pumped through the shaft 160 and used to conductively cool the bearing and seal assembly 165 and the target tube 155. The water is sufficient to cool the bearings 185 and the seals 187 in certain systems but not always in high-power systems. In these high-power systems, the bearings 185 tend to overheat, lose lubricant, and seize.

Seals 187 are used to maintain the pressure differential between the outside world and the inside of the vacuum chamber 115. Traditionally, these seals have been ferro-fluidic seals, which are costly and difficult to maintain. In particular, the ferro-fluid in the seals is subject to inductive heating in high-power AC systems. To prevent the seals from failing, they often require water cooling and high-temperature ferro-fluid―both of which add significant complexity and expense to the seal.

FIGURE 4 is a block diagram of a dual-supported, rotating-magnetron system 190 constructed in accordance with embodiments of the present invention. This system 190 includes a rotating tube 195 equally supported at both ends. The rotating tube 195 is connected to a shaft 200 that is coupled to a bearing and seal assembly 205, a power coupling 210, a rotation drive 215, and a water supply 220. The opposite end of the rotating tube is supported by a support arm 225 and a bearing (shown with the support arm 225). The tube 195 is shown in a horizontal position, but it can also be positioned vertically. A power coupling 210 is any means, which couples electrical power from a power source either via the shaft or directly to the tube, e. g. brushes. Thus, the current flows from a power coupling through the shaft or directly to the rotating tube. Current means substantially alternating current, because only alternating currents cause eddy currents. Non-ideal direct currents may comprise superimposed alternating currents.

The bearings 230 in the bearing and seal assembly 205 are subjected to the inductive heating effects in a high-power AC system. To prevent overheating and failure, the bearings 205 can be made of a non-metallic material such as ceramic. Ceramic bearings, however, are typically expensive and require a significant lead time to acquire. To limit the costs, bearings with metallic races and ceramic balls can be used. These hybrid bearings generally require cooling of the races. In the present invention, the cooling is provided by the water supply system 220.

In an alternate embodiment, high-temperature metallic bearings that run dry can be used instead of ceramic bearings. These metallic bearings heat like ordinary bearings but do not lose lubricant at high temperatures. One such bearing is constructed of a cobalt alloy known as Mp35N and is sold by Impact Bearings of Capo Beach, California. This bearing is presently rated to operate at 520 C and is considerably cheaper than a ceramic bearing. Another metallic bearing that can be used in the present invention is a standard steel bearing possibly coated with Molydisulfide or TiN. These bearings are presently rated to operate at 300 C.

Referring again to Figure 4, power is delivered to the shaft 200 and the rotating tube 195 through the power coupling 210. Power couplings are typically made of rotating brushes that degrade over time due to normal wear and debris. The traditional rotating brushes also introduce undesirable electrical noise into the electrical signal. In embodiments of the present invention, these traditional power couplings are replaced with liquid-metal connectors that use liquid metal, such as mercury, bonded to the contacts to form the electrical connection. An exemplary liquid-metal connector is manufactured by Mercotac located in Carlsbad, California.

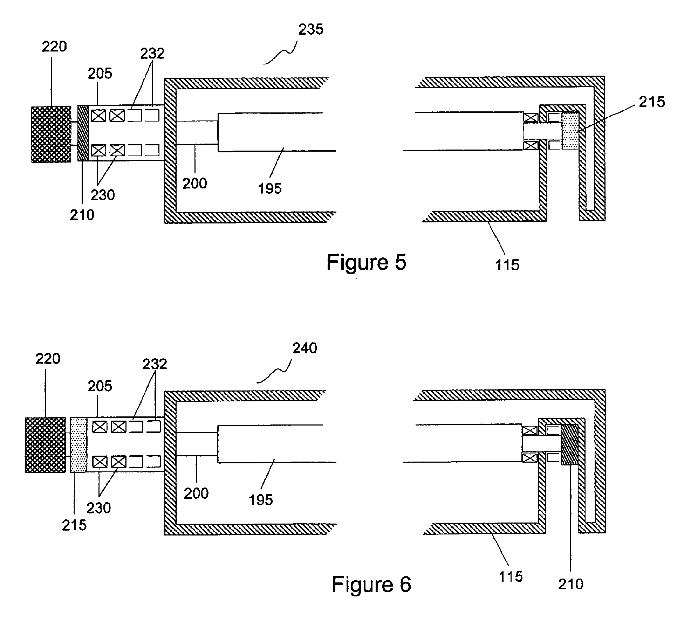

Referring now to Figure 5, it is an alternate embodiment 235 of the present invention. This embodiment is similar to the embodiment shown in Figure 4 except that the rotation drive system 215 has been moved to the opposite end of the tube 195. The rotation drive 215 and a supporting bearing (not shown) are located in a cavity that is outside the vacuum chamber 115.

Figure 6 is yet another embodiment 240 of the present invention. This embodiment includes a power coupling 210 located in a cavity outside the vacuum chamber 115. The support bearing (not shown) may be prone to inductive heating and can be made of a non-metallic substance or a material that can withstand the heating.

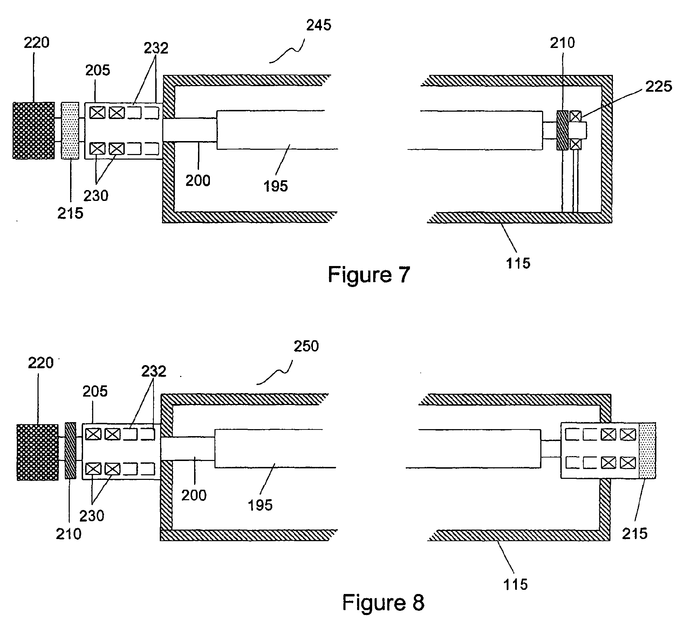

Figure 7 is a block diagram of an alternate rotating-magnetron system 245 with a power coupling 210 through the bottom of the chamber 115. The power coupling 210 in this system is inside the vacuum chamber 115. The power feed 210 can include a typical slip ring or a liquid-metal rotating connector.

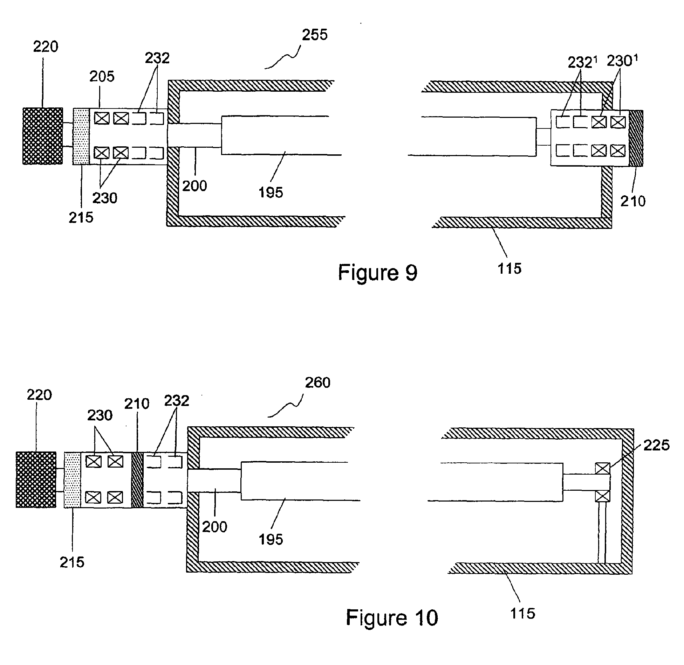

Figures 8 and 9 are alternate embodiments of the present invention. Figure 8 is a block diagram of rotating magnetron system 250 with a rotation drive 215 through the chamber wall. Figure 9 is a block diagram of rotating magnetron system 255 with a power feed 210 through the chamber wall.

FIGURE 10 is a block diagram of a rotating magnetron system 260 with a front power coupling 210. In this embodiment, the power coupling 210 is located in front of the bearings 230 but behind the and seals 232. When current is introduced into this power-coupling system 210, it flows through the rotating tube and not completely through the bearings 230. Thus, the bearings 230 can be metallic because they are not subject to the full inductive heating caused by the electrical current. In certain cases, the bearings 230 might be subject to ancillary heating and the bearings would need to be high-temperature bearings.

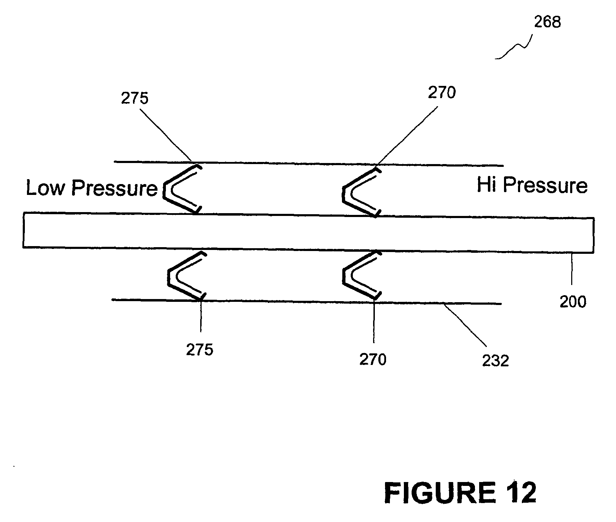

The seals in this embodiment would be subject to inductive heating. Accordingly, conductive components would need to be minimized or eliminated. Figure 12, which is discussed below, shows one acceptable seal design.

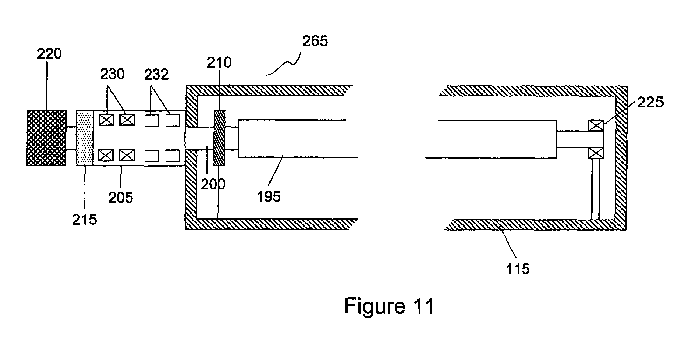

FIGURE 11 is a block diagram of rotating-magnetron system 265 with a power-coupling 210 inside the vacuum chamber 115. When current is introduced into this power coupling 210, it flows through the rotating tube but not through the bearings 230 or the seals 232. Thus, both components can be made of ordinary materials, thereby reducing complexity and costs.

FIGURE 12 is a block diagram of vacuum-seal assembly 268. In this embodiment, two pairs of band loaded seals 270 and 275 are positioned against the shaft 200. A springloaded seal could be used instead of a band seal. The open end of the seals 270/275 is pointed toward the high-pressure side of the seal assembly 268. The band seals 270/275 include a sealing component such as viton, buna rubber, or Teflon. Support is added to the sealing component by a load structure such as metal. To limit inductive heating, the load structure could be formed of stainless steel.

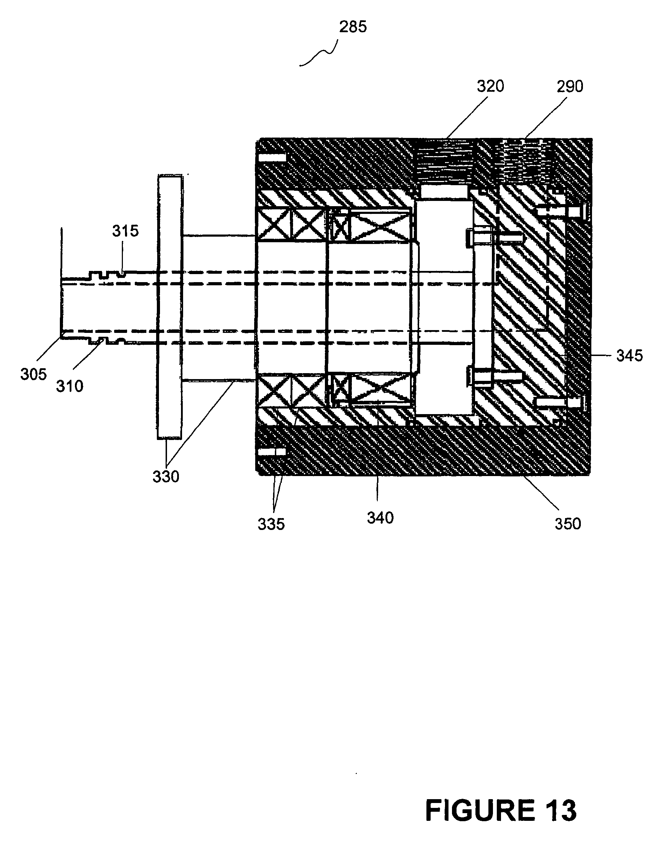

Referring now to FIGURE 13, it is a schematic of a rotary union that can be used to provide water from the water supply 220 to the shaft 200 and tube 195 (shown in Figure 4). This embodiment includes a water inlet 290 that could be connected to the water supply 220. Water flows through the inlet 290 and into an inner shaft (not shown) within the outer shaft 200. The water then flows to the end of the outer shaft 200 or tube 195 and returns along the inner surface of the tube 195 and shaft 200 and out the water return 320.

The water inlet 290 is coupled to the inner shaft through connector 305. This connector 305 can be profiled to prevent it from rotating with the outer shaft 200. It can also include a groove for an O-ring 310 and a slot 315 for a key or set screw.

The outer shaft 200 is connected to the flange assembly 330 by a quick coupler, bolts or other connector. When the quick coupler, for example, is disengaged, the rotary union 285 can be disengaged from the outer shaft 200 and the inner shaft (not shown) so that the tube 195 can be quickly replaced.

Because the outer shaft 200 rotates, the flange assembly 330 is configured to rotate on bearings 335. And to prevent water from escaping from the flange assembly 330, a face seal 340 is used to form a water-tight connection. The face seal 340 can be formed of silicon carbide. An exemplary face seal is manufactured by Garlock Sealing Technologies of Palmyra, New York.

In certain embodiments, a lip seal can be used instead of a face seal. Lip seals, however, are highly susceptible to particles and debris. If a particle gets caught between the lip (rubber) and the shaft it will both wear into the shaft and will destroy the rubber lip―leading to leaks and a premature shaft replacement. To prevent this type of damage, lip seals are often combined with water filtration systems down to 50 micron. This filtration requires significant expense, including monthly maintenance to clean or change the filters.

The bearings 335, seals 340, inlet 290, and return 320 are housed inside a stainless steel housing 345. This housing 345, which can be formed of other materials, is encased in an electrically and/or thermally insulating casing 350 made of, for example, Delrin, Teflon, and/or plastic. This casing prevents condensation, thereby dramatically reducing the risk of direct electrical shock and electrical shorts. Condensation and leaks are a problem with traditional rotary-union designs. Some manufacturers drain off any excess water and others provide leak detection hardware to address the problem.

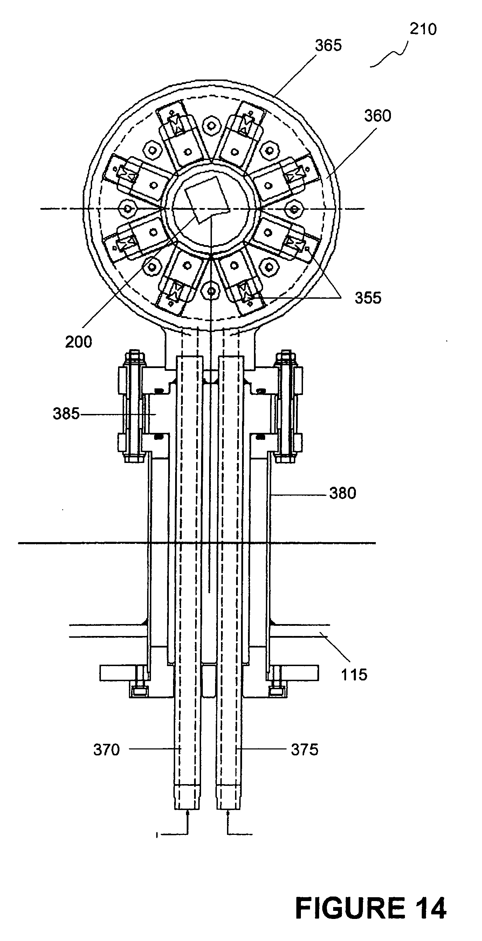

FIGURE 14 is a cross-section view of one embodiment of an electrical connector 210. This connector 210 is a slip-ring style connector that can operate inside the vacuum chamber 115 even though no humidity exists in the vacuum chamber for lubrication.

This connector 210 includes a plurality of brushes 355 located inside an outer housing 360 that is coated or covered with a non-conductive material 365. The brushes 355 can be formed of a low-resistance material such as silver graphite. Exemplary brushes are manufactured by Advance Carbon Products of Hayward, California. The brushes 350 engage the rotating shaft 200 and transfer power from the outer housing 360 to the shaft 200. Power is delivered to the outer housing 360 through the water inlet 370 and/or the water return 375, which are generally formed of copper.

The water inlet 370 and water return 375 circulate water through the outer housing 360. The water cools the outer housing 360 and the brushes 355. By keeping the brushes 355 cool, the life of the connector 210 is extended.

In one embodiment, the outer housing 360 is supported by an insulated support structure 380. The support structure 380 is coated with a non-conducting material to prevent arcing. Alternatively, the support structure 380 can be formed of a non-conductive material. The support member 380 and the outer housing 360 are connected through a seal assembly 385.

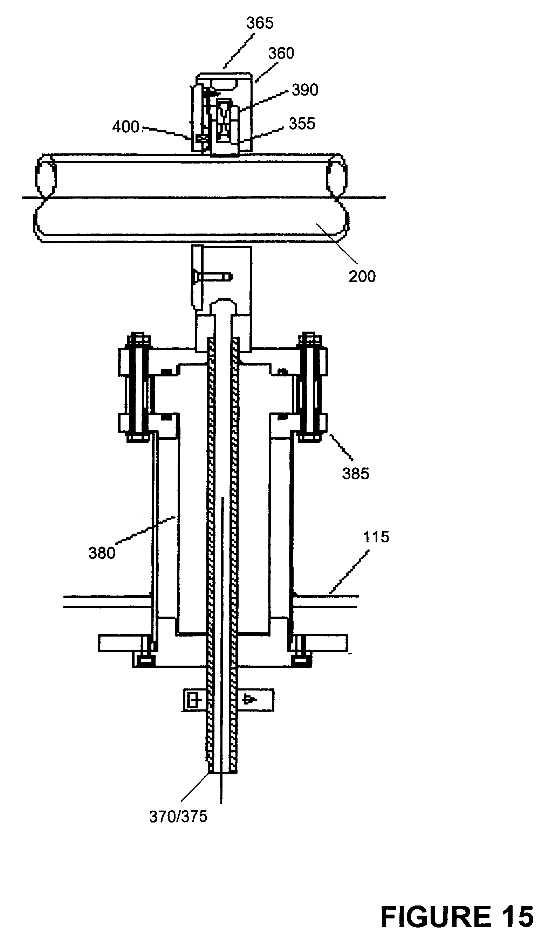

FIGURE 15 is a side view of the slip-ring assembly shown in Figure 14. This view illustrates additional details. For example, this embodiment illustrates the brush springs 390 that can be adjusted to control the engagement pressure between the brush 355 and the shaft 200. This embodiment also includes a contact assembly 400 to provide lateral pressure on the brushes 355, thereby increasing cooling abilities and conductive properties.

In conclusion, the present invention provides, among other things, a system and method for constructing and operating magnetron systems. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

1. A system for coating a substrate, the system comprising:
a vacuum chamber;
a rotatable tube positioned inside the vacuum chamber;
a shaft connected to the rotatable tube, the shaft partially outside the vacuum chamber;
a bearing positioned outside the vacuum chamber, the bearing configured to rotatably engage the shaft;
a seal positioned between the bearing and the vacuum chamber, the seal configured to provide a seal between the vacuum chamber and the shaft; and
a power coupler configured to deliver power to the rotatable tube, the power coupler positioned between the bearing and the seal to thereby limit the current that flows through the bearing.

2. The system of claim 1, wherein the power coupler is positioned inside the vacuum chamber.

3. The system of claim 1, wherein the rotatable tube and the shaft are integrated.

4. The system of claim 1, further comprising:
a drive system configured to rotate the shaft.

5. The system of claim 1, wherein the bearing comprises ceramic balls.

6. The system of claim 1, wherein the bearing comprises ceramic needles.

7. The system of claim 1, wherein the bearing comprises Mp35N.

8. The system of claim 1, wherein the power coupler is positioned outside the vacuum chamber.

9. The system of claim 1, wherein the power coupler comprises a water-cooled slip ring connector.

10. The system of claim 1, wherein the power coupler comprises a liquid-metal connector.

11. The system of claim 1, further comprising a support positioned inside the vacuum chamber, wherein the rotatable tube is continually supported by the support.

12. A system for coating a substrate, the system comprising:
a rotatable magnetron;
a vacuum chamber configured to house the rotatable magnetron;
a bearing configured to rotatably engage the rotatable magnetron;
a seal positioned between the bearing and the vacuum chamber; and
a power coupler configured to deliver power to the rotatable magnetron,
wherein the power coupler is positioned between the bearing and the seal.

13. The system of claim 12, wherein the power coupler is positioned inside the vacuum chamber.

14. A system for coating a substrate, the system comprising:
a vacuum chamber;
a rotatable tube positioned inside the vacuum chamber;
a shaft connected to the rotatable tube, the shaft partially outside the vacuum chamber;
a bearing positioned outside the vacuum chamber, the bearing configured to rotatably engage the shaft; and
a liquid-metal electrical connector engaged with the shaft, the liquid-metal electrical connector configured to deliver power to the rotatable tube.

15. The system of claim 14, wherein the bearing is a non-metallic bearing.

16. The system of claim 14, wherein the liquid-metal electrical connector is positioned between the bearing and the rotatable tube.

17. A system for coating a substrate, the system comprising:
a rotatable target;
a bearing configured to rotatably engage the rotatable target; and
a liquid-metal electrical connector configured to deliver power to the rotatable target.

18. The system of claim 17, wherein the liquid-metal electrical connector is positioned between the bearing and the rotatable target to limit the current that flows through the bearing.

19. The systems of claims 1, 12, 14 and 17, wherein the power coupler or electrical connector is coupled to an alternating current source.

20. The system of claim 19, wherein the alternating current source has a frequency between 1 and 10kHz.
